Europäisches Patentamt

European Patent Office

Office européen des brevets

(19)

(11) Numéro de publication: **0 149 948**
**B1**

(12) **FASCICULE DE BREVET EUROPEEN**

(45) Date de publication du fascicule du brevet:
**11.05.88**

(51) Int. Cl.⁴: **H 04 N 3/15, H 01 L 27/14**

(21) Numéro de dépôt: **84402743.3**

(22) Date de dépôt: **27.12.84**

(54) Perfectionnement aux dispositifs photosensibles à l'état solide.

(30) Priorité: **20.01.84 FR 8400887**

(43) Date de publication de la demande:
**31.07.85 Bulletin 85/31**

(45) Mention de la délivrance du brevet:
**11.05.88 Bulletin 88/19**

(84) Etats contractants désignés:
**DE GB SE**

(56) Documents cités:
**EP - A - 0 060 752**
**EP - A - 0 128 828**

(73) Titulaire: **THOMSON-CSF, 173, Boulevard Haussmann, F-75379 Paris Cédex 08 (FR)**

(72) Inventeur: **Arques, Marc, THOMSON-CSF SCPI 173, bld Haussmann, F-75379 Paris Cedex 08 (FR)**

(74) Mandataire: **Ruellan-Lemonnier, Brigitte et al, THOMSON-CSF SCPI 19, avenue de Messine, F-75008 Paris (FR)**

ACTORUM AG

## Description

La présente invention concerne les dispositifs photosensibles à l'état utilisés aussi bien dans le domaine du visible que de l'infrarouge.

En fait, la présente invention concerne plus particulièrement un perfectionnement aux dispositifs photosensibles à l'état solide décrits dans la demande de brevet français n° 83.09827 (=Fr-A-2 549 328 publ. 18.1.1985 ou EP-A1-128 828 publ. 19.12.1984) au nom de THOMSON-CSF, à savoir aux dispositifs photosensibles à l'état solide du type comportant au moins un détecteur relié à une zone d'intégration des charges elle-même reliée à un étage de lecture effectuant la conversion charge-tension, constitué par des moyens de lecture en tension reliés chacun à une zone d'intégration par l'intermédiaire d'une diode permettant de lire le potentiel correspondant à la quantité de charge dans la zone d'intégration, par au moins un moyen d'adressage pour adresser séquentiellement les moyens de lecture, et par des moyens de remise à zéro de la zone d'intégration précédemment lue. Toutefois, la présente invention peut aussi s'appliquer à l'étage de lecture des dispositifs photosensibles à l'état solide constitués principalement par des détecteurs reliés chacun à une zone d'intégration des charge et par un registre à décalage à transfert de charge recevant en parallèle les charges intégrées dans chaque zone d'intégration des charges et les délivrant en série vers un étage de lecture réalisant la conversion charge-tension.

Dans les deux types de dispositifs photosensibles décrits ci-dessus, la quantité de charge Q qui va être lue par l'étage de lecture ou étage de conversion charge-tension est tout d'abord stockée dans une capacité C où elle donne une variation de tension $\Delta V = \dfrac{Q}{C}$ . Toutefois, ces dispositifs sont en général limités par une valeur maximale de la variation de la tension $\Delta V_{max}$ admissible par le circuit. Or, la quantité de charge qui doit être intégrée est parfois difficile à prévoir, soit que la scène observée soit constituée par un éclairement moyen variable, soit que, notamment dans le cas des circuits hybrides utilisés plus particulièrement en infrarouge, les détecteurs à associer au dispositif de lecture soient de différente nature. En conséquence, le dimensionnement de la capacité doit être fait dans l'hypothèse de la charge maximale que l'on peut avoir à stocker. De ce fait, $C = \dfrac{Q_{max}}{\Delta V_{max}}$ . La capacité est donc surdimensionnée dans la plupart des cas d'utilisation des dispositifs photosensibles à l'état solide où la charge Q est en général inférieure à $Q_{max}$. Cela se traduit donc, pour le dispositif photosensible, par un facteur de conversion photon-variation de la tension de sortie, à savoir par un gain en sortie relativement faible. La présente invention a donc pour but de supprimer cet inconvénient en permettant de sélectionner la valeur de la capacité C en fonction des conditions d'éclairement et de la nature des détecteurs.

La présente invention a donc pour objet un dispositif photosensible à l'état solide du type comportant au moins un détecteur photosensible, chaque détecteur étant relié à une cellule d'intégration des charges elle-même reliée par l'intermédiaire d'un multiplexeur à un étage de conversion charge-tension précédé d'un premier moyen de stockage relié à un moyen de remise à niveau caractérisé en ce qu'il comporte de plus au moins un moyen de stockage des charges supplémentaire adjacent au premier moyen de stockage, le ou lesdits moyens de stockage supplémentaires étant commandés par des tensions de polarisation variables permettant de modifier la capacité de l'ensemble des moyens de stockage en fonction de la quantité de charges intégrées.

D'autres caractéristiques et avantages de la présente invention apparaîtront à la lecture de la description de divers modes de réalisation faite ci-après avec référence aux dessins ci-annexés dans lesquels:

– la figure 1 est une vue de dessus d'un dispositif photosensible du type barrette utilisé notamment dans l'infrarouge dont les cellules d'intégration des charges ont été modifiées conformément à un premier mode de réalisation de la présente invention;

– la figure 2 est une vue en coupe transversale schématique du dispositif de la figure 1, et des potentiels de surface correspondants dans le substrat dans lequel est intégré ledit dispositif;

– les figures 3a à 3d représentent respectivement une vue en coupe transversale schématique d'un autre mode de réalisation de la partie détection et intégration d'un dispositif photosensible à l'état solide conforme à la présente invention et l'évolution des potentiels de surface correspondants dans le substrat en fonction des tensions de polarisation appliquées sur les moyens de stockage;

– la figure 4 est une courbe donnant l'évolution de la tension en fonction des charges intégrées par le dispositif photosensible de la figure 3;

– les figures 5a à 5e représentent respectivement une vue en coupe schématique d'un autre mode de réalisation de la présente invention et l'évolution des potentiels de surface correspondants dans le substrat en fonction des tensions appliquées sur les différents moyens de stockage;

– la figure 6 est une courbe donnant l'évolution de la tension en fonction des charges intégrées dans le cas du dispositif de la figure 5;

– les figures 7a à 7c sont des vues de dessus de divers modes d'implantation des moyens de stockage supplémentaires conformément à la présente invention et;

– les figures 8a et 8b représentent respectivement une vue en coupe schématique d'un mode de réalisation de la présente invention dans le cas où le multiplexeur est un registre à décalage et l'évolution des potentiels de surface correspondants dans le substrat en fonction des tensions de polarisation appliquées.

Sur les différentes figures, les mêmes références désignent les mêmes éléments mais pour des raisons de clarté, les cotes et proportions des divers éléments ne sont pas respectées.

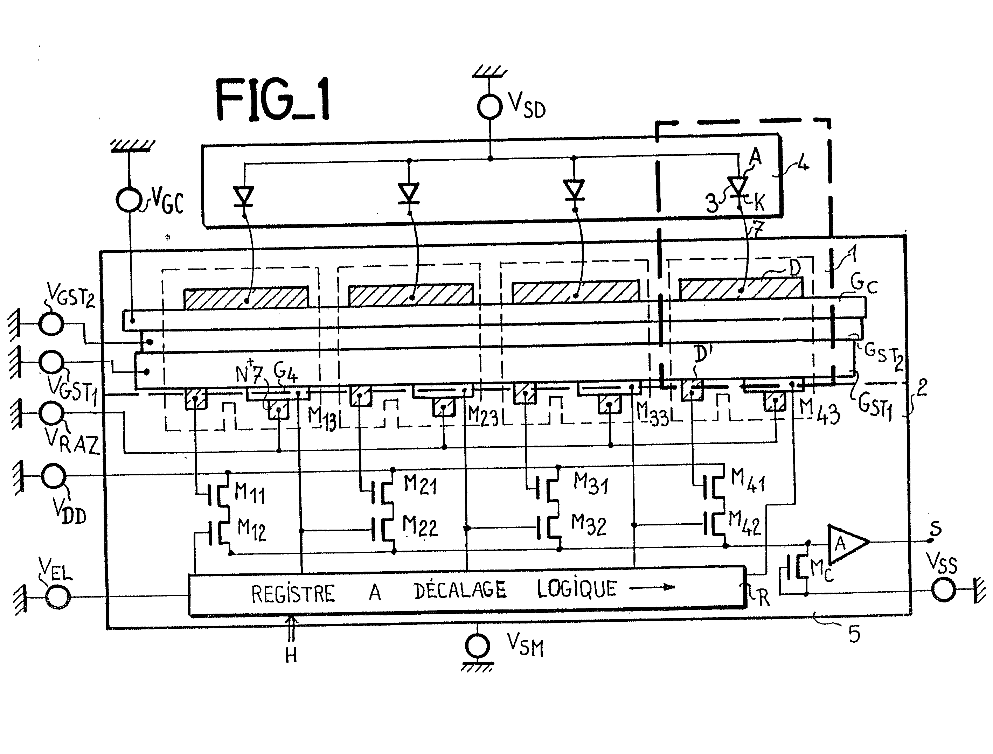

La figure 1 représente un dispositif photosensible utilisé notamment dans le domaine de l'infrarouge. De manière connue, ce dispositif photosensible est constitué de cellules 1 de détection photonique et d'intégration des charges et d'un étage de lecture 2 donnant en sortie un signal électrique d'analyse d'images. A titre d'exemple, on a représenté sur la figure 1 un dispositif comportant quatre cellules. Il est bien entendu que le dispositif selon l'invention peut comporter un nombre plus élevé de cellules. De même la figure 1 concerne un dispositif photosensible du type barrette mais la présente invention peut aussi s'appliquer à un dispositif photosensible du type matriciel comme décrit dans la demande de brevet n° 83.09827 au nom de la demanderesse.

Dans le domaine de l'infrarouge et comme représenté sur la figure 1, chaque cellule 1 comporte un détecteur photosensible 3 intégré sur un substrat semiconducteur 4 différent du substrat 5 sur lequel sont intégrés les autres éléments du dispositif photosensible et une zone d'intégration réalisée sur le substrat 5. Le substrat 4 est, de préférence, réalisé en tellurure de cadmiun et de mercure, en tellurure d'étain et de plomb ou en antimoniure d'indium. De même, le substrat 5 est de préférence réalisé en silicium de type P, mais il pourrait être réalisé en silicium de type N dans le cas de diodes de détection à cathode commune, en arséniure de gallium ou en tu tout autre matériau semiconducteur équivalent.

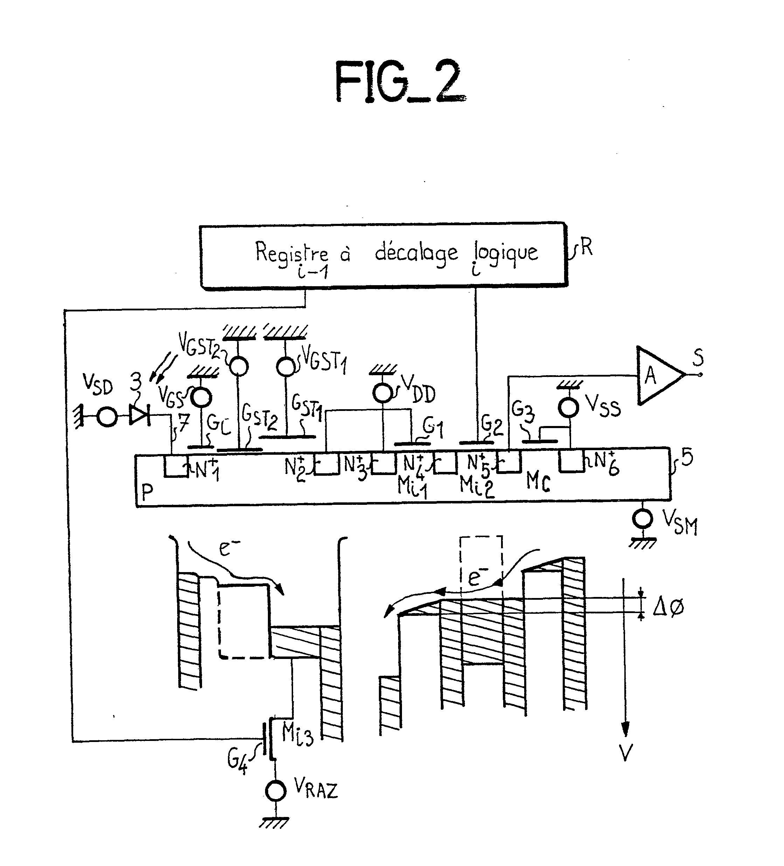

A titre d'exemple et comme représenté sur les figures 1 et 2, le détecteur photosensible 3 utilisé dans la présente invention est une photodiode. Toutefois, il est évident pour l'homme de l'art que l'invention s'applique quel que soit le détecteur utilisé.

Ainsi, comme représenté sur les figures 1 et 2, l'anode A de la photodiode 3 reçoit une tension de polarisation $V_{SD}$. Sa cathode K est reliée par une connexion 7 à la zone d'intégration des charges qui permet d'intégrer dans le substrat 5 les charges créées dans la photodiode 3 par le rayonnement à détecter symbolisé par des flèches ondulées sur la figure 2.

D'autre part, chaque zone d'intégration des charges réalisées sur le substrat semiconducteur 5 qui est polarisé à une tension $V_{SM}$, comporte une diode D constituée par une zone de type N réalisée dans le substrat semiconducteur 5 en silicium de type P. Cette zone est désignée par la référence $N_1^+$ sur la figure 2. Chaque diode est reliée par une connexion 7 à la cathode K de la photodiode correspondante. D'autre part, conformément à la présente invention, une grille $G_C$ reliée à la tension de polarisation $V_{GC}$ separe chaque diode D d'une première capacité de stockage des charges constituée par une grille $G_{ST2}$, une couche d'isolant et le substrat. Cette première capacité de stockage des charges est suivie d'une seconde capacité de stockage des charges constituée aussi par une grille $G_{ST1}$ une couche d'isolant et le substrat. Les capacités de stockage symbolisées par les grilles $G_{ST2}$ et $G_{ST1}$ sont polarisées, de la manière qui sera décrite ci-après par deux tensions de polarisation différentes $V_{GST2}$ et $V_{GST1}$.

De même, comme représenté sur les figures 1 et 2, l'étage de lecture 2 comporte quatre moyens de lecture en tension ou étages de conversion charge-tension constitués par des transistors MOS $M_{I1}$ montés en suiveur. La grille $G_1$ de chaque transistor MOS $M_{I1}$ est reliée à une diode de lecture D' adjacente à la capacité de stockage $G_{ST1}$ de chaque cellule 1 de détection et d'intégration des charges. Cette diode D' est réalisée par une diffusion de type N désignée par la référence $N_2^+$ sur la figure 2. Le drain des transistors MOS $M_{I1}$ réalisé par la diffusion de type N référence $N_3^+$ sur la figure 2 est relié à une tension de polarisation $V_{DD}$. D'autre part, la source des transistors MOS $M_{I1}$ est connectée par l'intermédiaire des transistors MOS $M_{I2}$ jouant le rôle d'interrupteurs à une charge $M_C$. Cette charge $M_C$ est constituée par un transistor MOS à dépletion dont la grille $G_3$ est connectée à la source réalisée par la diffusion de type N référencée $N_6^+$ sur la figure 2, cette source étant polarisée par une tension continue $V_{SS}$. D'autre part, chaque grille $G_2$ des transistors MOS interrupteurs $M_{I2}$ est reliée à une des sorties d'un registre à décalage logique R à entrée série et sorties parallèles. Ce registre à décalage R permet d'adresser et de rendre passant un des transistors MOS $M_{I2}$, en conséquence d'effectuer le multiplexage des différents étages suiveurs.

L'étage de lecture 2 comporte de plus des moyens de remise à zéro. Ces moyens de remise à zéro sont réalisés par des transistors MOS $M_{I3}$ dont la porte $G_4$ est connectée à la sortie du registre à décalage logique R correspondant au prochain étage suiveur. La source induite des transistors MOS $M_{I3}$ est constituée par la capacité de stockage $G_{ST1}$ correspondante et le drain réalisé par une diffusion de type N référencée $N_7^+$ est connecté à une tension continue $V_{RAZ}$. Dans le mode de réalisation représenté, on utilise le même registre à décalage logique R pour commander les transistors MOS interrupteurs $M_{I2}$ et les transistors MOS $M_{I3}$ de remise à zéro, ce qui nécessite un étage de plus que le nombre de cellules ou l'utilisation d'un registre à décalage bouclé.

On expliquera maintenant le fonctionnement du dispositif décrit ci-dessus avec référence en particulier à la partie inférieure de la figure 2. Cette partie représente le potentiel de surface dans le substrat 5 lors de la lecture d'un étage lorsqu'une charge Q de faible valeur a été stockée sous la grille de stockage $G_{ST1}$, la grille de stockage $G_{ST2}$ n'étant pas utilisée.

La partie gauche représente donc le potentiel sous la zone d'intégration d'une cellule 1 qui est réalisée de manière connue par la diode D, la grille $G_C$ et les deux capacités de stockage $G_{ST1}$ et $G_{ST2}$. Cette zone constitue un transistor MOS dont la diode D est la source et dont la capacité de stockage $G_{ST1}$ dans le mode de réalisation représenté, à savoir dans le cas d'un faible éclairement, est le drain induit. En effet, dans ce cas, la tension de polarisation $V_{GST2}$ est portée à un niveau bas et la grille $G_{ST2}$ joue le rôle de grille de passage pour les électrons.

Le transistor MOS d'entrée est donc polarisé en régime de saturation, car la tension $V_{GST1}$ appliquée à la grille $G_{ST1}$ est supérieure aux tensions $V_{GC}$ et $V_{GST2}$ appliquées sur les grilles $G_C$ et $G_{ST2}$. Le niveau des charges sur la diode D s'aligne sur le potentiel proche du potentiel constant existant sous la grille $G_C$. L'anode A de la photodiode est polarisée par la tension continue $V_{SD}$ choisie pour être, par exemple, égale à zéro Volt.

Les charges créées dans le détecteur par le rayonnement électromagnétique sont stockées dans la capacité créée sous la grille de stockage $G_{ST1}$ polarisée par $V_{GST1}$, comme cela est représenté symboliquement sur la figure 2 où les zones hachurées indiquent la présence de porteurs minoritaires par rapport au substrat 5.

Les charges créée dans le détecteur sont donc tout d'abord stockées sous la grille de stockage $G_{ST1}$. Toutefois, conformément à la présente invention, si la charge à stocker est supérieure à la capacité de stockage $G_{ST1}$, la tension de polarisation $V_{GST2}$ est commutée à un niveau haut tel que par exemple $V_{GST2}$ égale $V_{GST1}$, ce qui permet alors de stocker les charges non plus uniquement sous $G_{ST1}$ mais aussi sous $G_{ST2}$ comme représenté en tiretés sur la figure 2.

En ce qui concerne la lecture des charges intégrées dans la zone d'intégration, elle est réalisée de manière connue lorsque la sortie i correspondante du registre à décalage R est au niveau logique 1 de sorte que la grille du transistor MOS $M_{I2}$ reçoive une tension élevée rendant passant ledit transistor, toutes les grilles des autres transistors MOS jouant le rôle d'interrupteur recevant un niveau logique «O» bloquant lesdits transistors. Dans ce cas, ledit transistor MOS $M_{12}$ se comporte comme une résistance, le transistors MOS $M_C$, à savoir la charge, se trouve connecté au transistor suiveur $M_{I1}$ et on obtient donc un étage suiveur classique, la tension de polarisation $V_{DD}$ étant choisie très supérieure à la tension de polarisation $V_{SS}$ comme représenté sur la figure 2.

La diffusion $N_2^+$ réalisée à droite de la grille de stockage $G_{ST1}$ et connectée à la grille $G_1$ du transistor MOS $M_{I1}$ permet d'obtenir au niveau de la grille un potentiel représentatif du potentiel sous la grille de stockage $G_{ST1}$ dans le mode de réalisation représenté.

De plus le potentiel au niveau de la diffusion $N_5^+$ s'aligne sur le potentiel au niveau de la diffusion $N_4^+$, car le transistor $M_{I2}$ est équivalent à une résistance. Or le potentiel au niveau de la diffusion $N_4^+$ est fonction du potentiel sou la grille $G_1$, car dans un étage suiveur la différence de potentiels $\Delta \emptyset$ est une constante. On obtient donc au niveau de la diffusion $N_5^+$ une tension représentative de la tension sous la grille de stockage $G_{ST1}$. Cette tension est envoyée à travers un amplificateur A sur la borne de sortie S du dispositif photosensible.

Après avoir lu l'information sur l'entrée i, on décale le niveau logique «1» du registre à décalage R d'un étage sous l'action de l'horloge H. On réalise alors la lecture de l'entrée i+1.

Le niveau logique «1» est alors appliqué sur la grille $G_4$ du transistor MOS $M_{I3}$ de remise à zéro qui est rendu passant. Les charges qui se trouvent sous la grille de stockage $G_{ST1}$ sont alors évacuées vers la source de tension $V_{RAZ}$ qui peut être choisie égale à la tension $V_{DD}$. On effectue ainsi la réinitialisation de la valeur de la capacité de stockage de l'entrée i pendant la lecture de l'entrée i+1. En fait pendant cette remise à zéro de la capacité de stockage, les charges délivrées par la photodiode sont directement évacuées vers la source de tension $V_{RAZ}$ et donc inexploitées.

Ainsi, conformément à la présente invention, lors de l'intégration des charges on utilise la capacité créée sous la grille $G_{ST1}$, lorsque la quantité de charge à intégrer est faible, ou bien si cette quantité est importante on commute la tension $V_{GST2}$ à un niveau haut pour stocker alors les charges à la fois sous la grille $G_{ST1}$ et sous la grille $G_{ST2}$. Pour pouvoir réaliser ultérieurement la lecture des charges et la remise à niveau de la cellule d'intégration 1, il est nécessaire, conformément à la présente invention, que la première capacité $G_{ST1}$ soit adjacente à la diode de lecture D' et à la grille $G_4$ du transistor MOS $M_{I3}$ de remise à niveau comme représenté sur la figure 2. La tension $V_{GST2}$ peut être identique ou inférieure à la tension $V_{GST1}$.

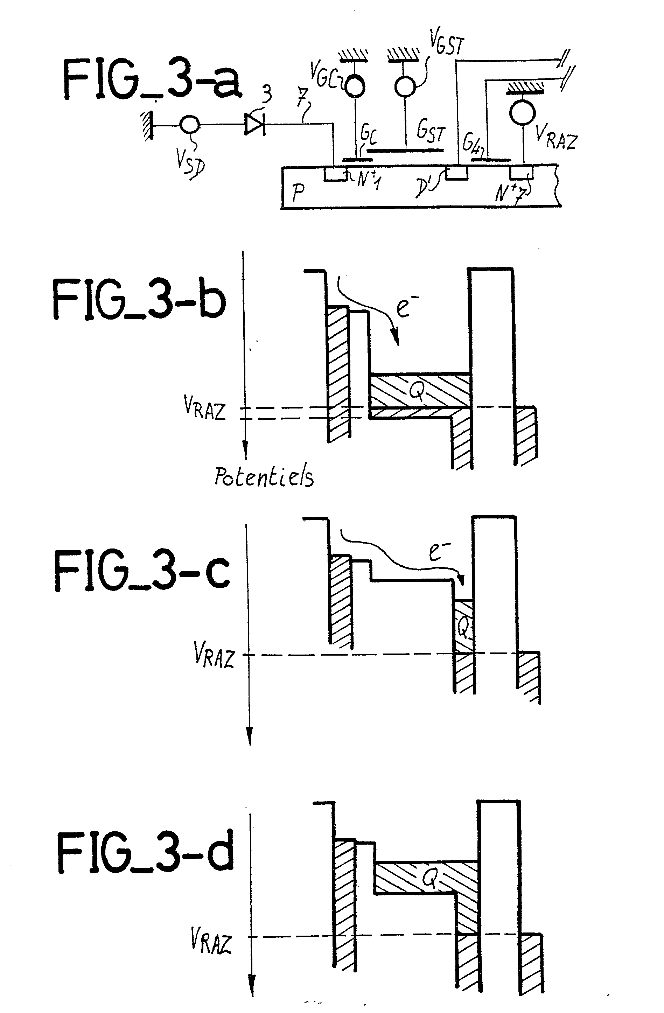

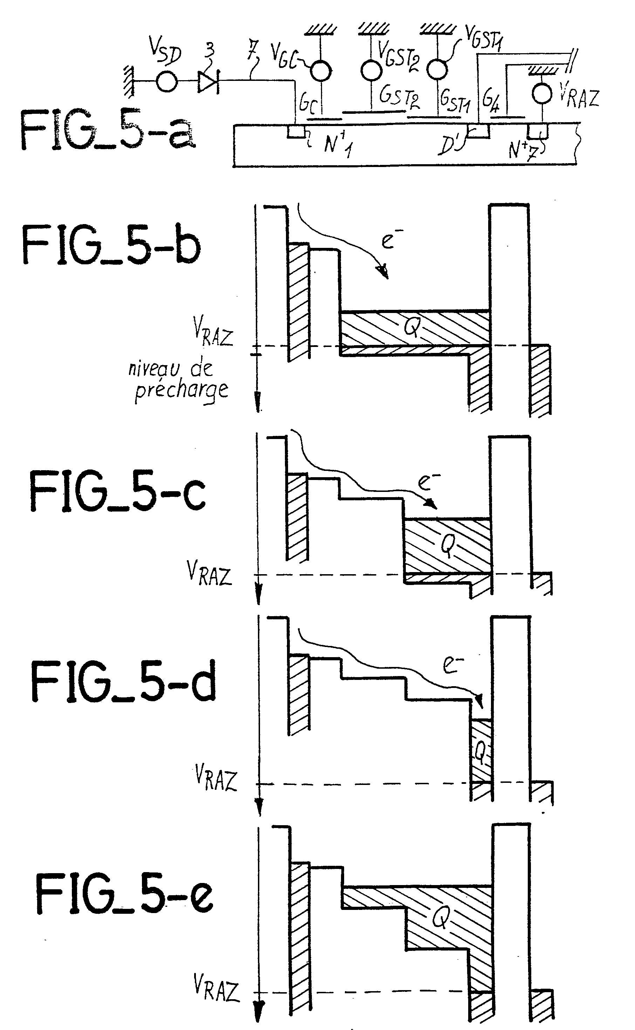

La figure 3a représente un autre mode de réalisation de la cellule d'intégration d'un dispositif photosensible à l'état solide dont les autres parties sont identiques aux dispositifs photosensibles des figures 1 et 2.

Dans le mode de réalisation de la figure 3a, une seule grille de stockage $V_{GST}$ est prévue au niveau de la cellule d'intrégration mais, comme représenté sur cette figure, la grille $G_{ST}$ est adjacente à la diode de lecture D' réalisée par une diffusion de type N référencé $N_2^+$ qui est elle-même adjacente à la grille $G_4$ suivie de la diffusion $N_7^+$, l'ensemble représentant le transistor $M_{I3}$ de remise à niveau.

Avec cette configuration, les différents moyens de stockage des charges délivrées par les photodiodes 3 sont constitués par la diode D' reliée à la grille $G_1$ du transistor MOS $M_{I3}$ et par la grille de stockage $G_{ST}$ polarisée par la tension $V_{GST}$ qui peut être portée à un niveau haut ou à un niveau bas selon la quantité de charge à intégrer. En effet, la diode D' peut être utilisée comme capacité de stockage, car du fait de son adjacence avec la grille $G_4$, les électrons stockés sur la diode D' et sur la grille $G_1$ peuvent être évacués par l'intermédiaire de la grille $G_4$ vers la tension de remise à niveau $V_{RAZ}$ sans passer sous la grille de stockage $G_{ST}$.

On montrera maintenant avec référence aux figures 3b à 3d, les différentes possibilités de fonctionnement du mode de réalisation de la figure 3a.

Lorsque la charge Q à stocker est importante, la tension de polarisation $V_{GST}$ est à un niveau haut supérieur à la tension de remise à niveau $V_{RAZ}$ qui constitue le niveau de précharge comme représenté sur la figure 3b. Dans ce cas, le fonctionnement est identique à celui décrit avec référence aux figures 1 et 2 et les électrons délivrés par les photodiodes 3 sont stockés à la fois sous la grille $G_{ST}$, dans la diode D' et sur la grille $G_1$. Soit $C_{ST}$ la capacité MOS sous $G_{ST}$ et $C_0$ la somme de la capacité de la diode D' et sur la grille $G_1$, la capacité de stockage totale $C_{STT}$ vaut dans ce cas $C_{STT}=C_{ST}+C_0$.

Lorsque la charge Q à stocker est particulièrement faible, on réduit alors la tension de polarisation $V_{GST}$ à une valeur proche de $V_{GC}$ de façon que le potentiel sous $G_{ST}$ en l'absence de charge soit proche mais légèrement supérieur à celui sous $G_C$ comme représenté sur la figure 3c. Dans ce cas, les électrons délivrés par les photodiodes 3 passent alors sous la grille $G_{ST}$ et viennent se stocker dans la diode D' et sur la grille $G_1$. Dans ce cas, la capacité de stockage totale $C_{STT}$ vaut $C_{STT}=C_0$.

Comme représenté sur la figure 3d, il est possible d'envisager un cas intermédiaire dans lequel la tension de polarisation $V_{GST}$ est portée à un niveau intermédiaire compris entre la tension de remise à niveau $V_{RAZ}$ et la tension de polarisaton de la grille $V_{GC}$.

Dans ce cas, les électrons délivrés par les photodiodes 3 sont tout d'abord stockés sous la diode D' et la grille $G_1$ puis sous la grille de stockage $G_{ST}$.

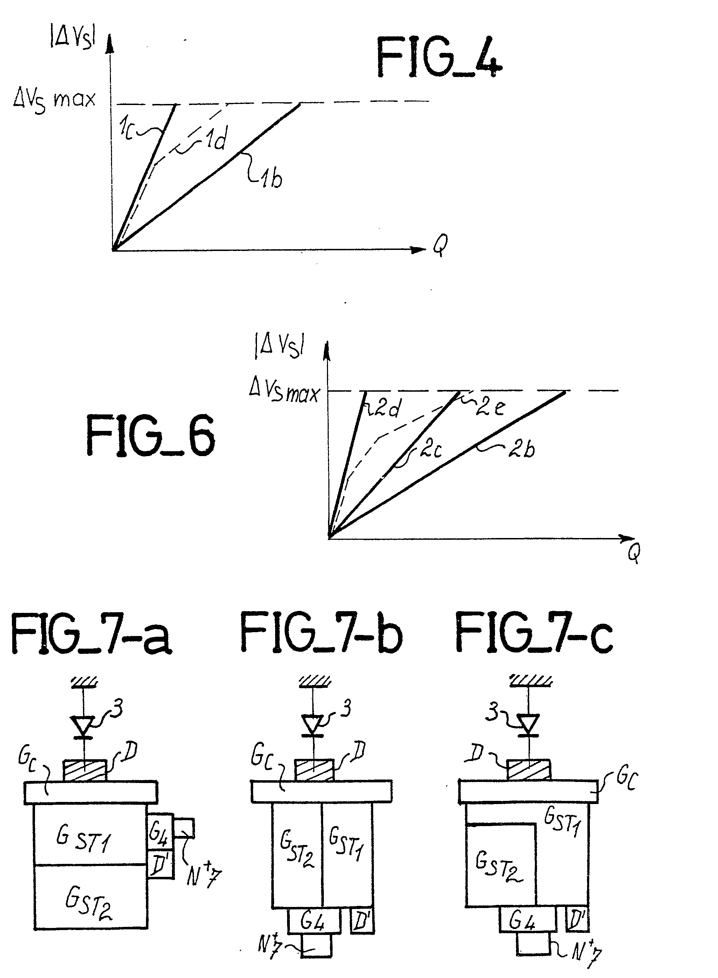

La figure 4 représente la variation de la tension de sortie du système en fonction de la charge Q intégrée. La droite 1b correspondant au cas de la figure 3b a une pente proportionnelle à

$$\frac{1}{C_0+C_{St}T}$$ , la droite 1c correspondant au cas de la figure 3c à une pente proportionnelle à $\frac{1}{C_0}$ .

D'autre part, la courbe 1d correspond au cas de la figure 3d dans lequel la tension de polarisation de $G_{ST}$ est une tension intermédiaire entre les deux valeurs précédentes. Lorsque la charge Q à stocker est faible, elle n'est stockée que sous $C_0$ et la pente de la courbe 1d est dans ce cas proportionnelle à $\frac{1}{C_0}$ , puis lorsque la charge Q est plus importante, elle est stockée en parallèle sur $C_0$ et $C_{ST}$ et la pente de la courbe 1d est dans ce cas proportionnelle à $\frac{1}{C_0+C_{ST}}$ . En examinant les différentes courbes de la figure 4, on voit que, dans le cas où la charge à intégrer est faible, il est préférable de fonctionner avec une capacité de stockage $C_0$ plus petite de manière à obtenir des variations de tension en sortie plus importantes à savoir un gain de sortie plus élevé.

On décrira maintenant avec référence aux figures 5a à 5e un troisième mode de réalisation de la cellule d'intégration d'un dispositif photosensible du type de celui des figures 1 et 2.

Dans ce cas, la grille $G_{ST}$ a été remplacée par deux grilles $G_{ST1}$ et $G_{ST2}$ formant les capacités MOS $C_{ST1}$ et $C_{ST2}$ polarisées par deux tensions de polarisation différentes $V_{GST1}$ et $V_{GST2}$.

On décrira maintenant les diverses possibilités de fonctionnement de cette cellule d'intégration avec référence aux figures 5b à 5e.

Dans le cas d'une carge Q à intégrer importante, les tenssions de polarisation $V_{GST2}$ et $V_{GST1}$ sont toutes deux portées à un niveau haut identique supérieure à la tension de remise à niveau $V_{RAZ}$, comme représenté sur la figure 5b. Dans ce cas la capacité de stockage totale $C_{TT}$ est égale: $C_{TT}=C_0+C_{ST1}+C_{ST2}$ dans laquelle:

$C_0$ correspond à la capacité de la diode D' et de la grille $G_1$, $C_{ST1}$ à la capacité sous la grille $G_{ST1}$ et $C_{ST2}$ à la capacité sous la grille $G_{ST2}$.

Dans le cas où la charge Q est moins importante, la tension de polarisation $V_{GST2}$ peut être aménée à un niveau bas légèrement supérieur au niveau de la tension de polarisation de la grille $G_C$, comme représenté sur la figure 5c. Dans ce cas, la capacité totale de stockage des charges est égale à: $C_{TT}=C_0+C_{ST1}$.

Dans le cas où la quantité de charges à stocker Q est très faible, il es possible, comme dans le mode de réalisation de la figure 3a, de ne stocker les charges que dans la diode D' et sur la grille $G_1$ comme représenté sur la figure 5d. Dans ce cas la capacité de stockage totale $C_{TT}$ est égale à: $C_{TT}=C_0$.

Comme pour le mode de réalisation de la figure 3a, il est possible de polariser $V_{GST2}$ et $V_{GST1}$ à des tensions différentes telles que $V_{GST1}$ soit inférieure à $V_{RAZ}$ et $V_{GST2}$ soit inférieure à $V_{GST1}$ mais supérieure à $V_{GC}$ comme représenté sur la figure 5e. Dans ce cas, les charges Q sont tout d'abord intégrées dans la diode D' et sur la grille $G_1$ puis sous la grille $G_{ST1}$ puis ensuite sous la grille $G_{ST2}$.

Les courbes donnant la variation de tension de sortie en fonction de la charge Q correspondant aux figures 5b à 5c ont été représentées sur la figure 6. Dans ce cas, la droite 2b présente une pente proportionnelle à $\frac{1}{C_0+C_{ST1}+C_{ST2}}$ , la droite 2c une pente proportionnelle à $\frac{1}{C_0+C_{ST1}}$ et la droite 2d une pente proportionnelle à $\frac{1}{C_0}$ .

De plus la courbe 2e est constituée par trois droites ayant respectivement une pente proportionnelle à $\frac{1}{C_0}$ puis proportionnelle à $\frac{1}{C_0+C_{ST1}}$ puis proportionnelle à $\frac{1}{C_0+C_{ST1}+C_{ST2}}$ .

Sur les figures 7a à 7c on a représenté à titre d'exemples, différentes dispositions possibles pour les grilles $G_{ST1}$ et $G_{ST2}$. Une des contraintes imposées lors du choix de la disposition des grilles $G_{ST1}$ et $G_{ST2}$ est que la diode de lecture D' ainsi que la grille $G_4$ du transistor MOS $M_{l3}$ de remise à niveau doivent être adjacentes à la première grille de stockage que l'on souhaite pouvoir utiliser. Cette grille est référencée $G_{ST1}$ dans les différents modes de réalisation des figures 7a à 7c. Les autres conditions d'adjacence sont donc facultatives. Toutefois, comme représenté dans la figure 7a, la diode D' peut aussi être positionnée à cheval sur $G_{ST1}$ et $G_{ST2}$ et $G_4$ n'être adjacente qu'à $G_{ST1}$, ou bien, comme représenté sur les figures 7b et 7c, la diode D' peut n'être adjacente qu'à la grille $G_{ST1}$ et la grille $G_4$ être positionnée à cheval sur $G_{ST1}$ et $G_{ST2}$. D'autre part dans le cas des figures 7a à 7c, les électrons en provenance du détecteur ne sont pas obligés de passer sous la capacité de stockage supplémentaire $G_{ST2}$ puisque la grille $G_{ST1}$ est adjacente à la grille de contrôle $G_C$ prévue entre la diode de lecture D du photodétecteur et la première capacité de stockage $G_{ST1}$.

Il est évident pour l'homme de l'art que d'autres possibilités de dispositions pour les grilles $G_{ST1}$ et $G_{ST2}$ peuvent être envisagées sans sortir du cadre de la présente invention.

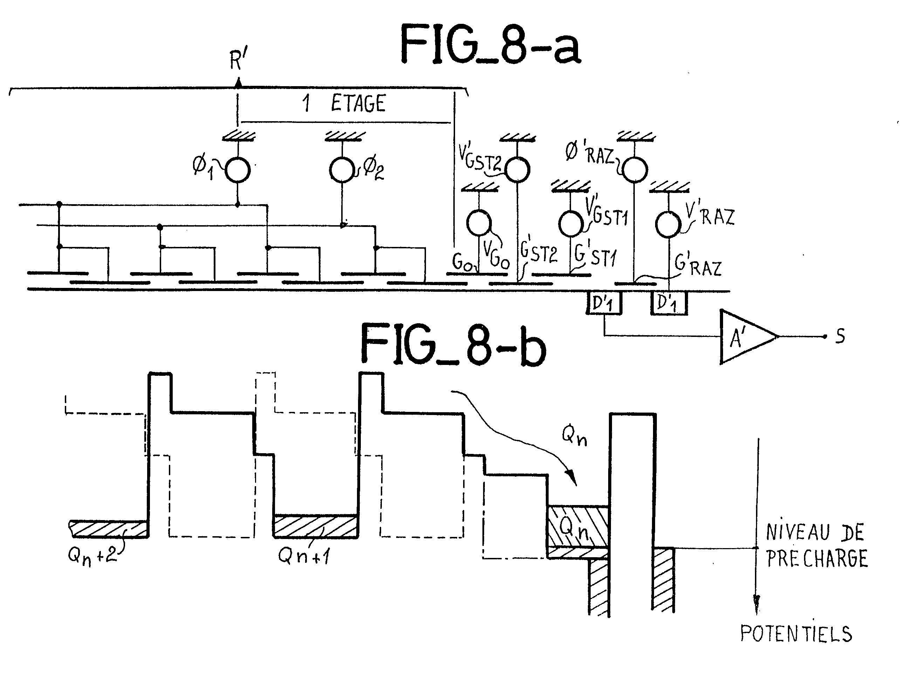

On décrira maintenant, avec référence aux figures 8a et 8b, un mode de réalisation de la présente invention utilisé dans un dispositif photosensible dans lequel le multiplexage est réalisé de manière tout à fait connue à l'aide d'un registre à décalage à transfert de charge R'. Dans ce cas, les cellules de détection et d'intégration des charges, qui n'ont pas été représentées sont identiques au mode de réalisation de la figure 1, à l'exception du fait qu'elles ne comportent qu'un seul niveau de moyens de stockage. Dans ce cas, chaque moyen de stockage est connecté à un étage du registre à décalage R qui transportent les charges intégrées en agissant sur les phases de commande $\varnothing_1$ et $\varnothing_2$ vers un étage de conversion charge-tension.

Comme représenté sur la figure 8a, l'étage de conversion charge-tension qui est séparé du registre R' par une grille de passage $G_O$ connectée par exemple à une tension fixe $V_{GO}$, est constituée d'un premier moyen de stockage $G'_{ST1}$ relié à une tension de polarisation portée à un niveau haut $V'_{GST1}$. Ce moyen de stockage est adjacent à une diode de lecture $D'_1$ reliée à un amplificateur A' et à un transistor de remise à niveau constitué par la grille $G'_{RAZ}$ reliée à une tension $\varnothing_{RAZ}$ qui peut être portée à un niveau haut ou à un niveau bas pour précharger la diode de lecture et par la diode $D'_1$ polarisée par la tension $V'_{RAZ}$.

Conformément à la présente invention, un moyen de stockage des charges supplémentaire constitué par la capacité $G'_{ST2}$ est prévu entre la grille $G_O$ et la capacité $G'_{ST1}$. Cette capacité $G'_{ST2}$ est connectée à une tension de polarisation $V'_{GST2}$ qui peut être portée à un niveau haut ou à un niveau bas selon la quantité de charges à lire. Comme représenté en tiretés sur la figure 8b. Le fonctionnement des deux moyens de stockage $G'_{ST1}$ et $G'_{ST2}$ est identique au fonctionnement des moyens de stockage $G_{ST1}$ et $G_{ST2}$ de la figure 1.

Dans ce mode de réalisation, l'utilisation de moyens de stockage supplémentaire ne permet pas de réduire les dimensions des cellules d'intégration et de stockage ainsi que du registre à décalage qui doivent être dimensionnés pour intégrer la charge maximale, mais elle permet d'accroître le gain du signal en sortie.

Il est évident pour l'homme de l'art que le dispositif photosensible de la figure 8a peut être modifié de nombreuses manières sans sortir du cadre de la présente invention. Ainsi le registre R' peut être à 3 ou 4 phases de commande. La grille $G_O$ peut être connectée à une tension fixe comme représenté sur la figure 8a ou à la phase $\varnothing_1$.

De plus, dans les modes de réalisation présentés ci-dessus, on a utilisé un ou deux moyens de stockage supplémentaires; toutefois il est évident pour l'homme de l'art qu'un nombre plus important de moyens de stockage peut être utilisé sans sortir du cadre de l'invention.

D'autre part en ce qui concerne la commande des tensions de polarisation $V_{GST}$ ou $V_{GST1}$ et $V_{GST2}$, soit ces tensions peuvent être positionnées en début d'utilisation en fonction de l'application ou du type de photodétecteurs utilisé, soit un asservissement peut être envisagé. Dans ce cas, l'asservissement prend en compte la tension de sortie, la compare à deux tensions de référence supérieure et inférieure et en fonction du résultat des comparaisons commute la tension de polarisation du moyen de stockage supplémentaire d'un niveau bas à un niveau haut ou vice-versa comme expliqué ci-dessus.

D'autre part, la présente invention a été décrite en se référant à un type de dispositif photosensible à l'état solide. Toutefois, il est évident que la présente invention peut s'appliquer à tous les types de dispositifs à l'état solide dans lesquels l'étage de conversion charge tension est précédé d'une capacité de stockage de manière à augmenter le gain en sortie. Toutefois, lorsque la présente invention est utilisée dans les dispositifs photosensibles à l'état solide comportant comme multiplexeur un registre à transfert de charge la présente invention ne peut être utilisée qu'au niveau de l'étage de lecture et ne permet pas de diminuer l'encombrement au niveau du registre à décalage qui doit dans tous les cas pouvoir transporter la charge maximale admissible.

**Revendications**

1. Un dispositif photosensible à l'état solide du type comportant au moins un détecteur photosensible (3), chaque détecteur étant relié à une cellule d'intégration des charges (1) elle-même reliée par l'intermédiaire d'un multiplexeur (R, $M_{l2}$, R') à un étage de conversion charge-tension ($M_{l1}$, $D_1$) précédé d'un premier moyen de stockage (D' et $G_1$, $G_{ST1}$, $G'_{ST1}$) relié à un moyen de remise à niveau ($M_{l3}$) caractérisé en ce qu'il comporte de plus au moins un moyen de stockage des charges supplémentaire ($G_{ST}$, $G_{ST2}$, $G'_{ST2}$) adjacent au premier moyen de stockage (D' et $G_1$, $G_{ST1}$, $G'_{ST1}$), le ou lesdits moyens de stockage supplémentaires étant commandés par des tensions de polarisation ($V_{GST}$, $V_{GST1}$, $V_{GST2}$, $V'_{GST2}$) variables permettant de modifier la capacité de l'ensemble des moyens de stockage en fonction de la quantité de charge intégrée.

2. Un dispositif selon la revendication 1 caractérisé en ce que le premier moyen de stockage des charges est constitué par la diode de lecture (D') de l'étage de conversion charge-tension et le ou les moyens de stockage supplémentaires sont constitués par des capacités MOS ($G_{ST}$, $G_{ST1}$, ou $G_{ST2}$).

3. Un dispositif selon la revendication 1 caractérisé en ce que le premier moyen de stockage ($G_{ST1}$, $G'_{ST1}$) et le ou les moyens de stockage supplémentaires ($G_{ST2}$, $G'_{ST2}$) sont constitués par des capacités MOS.

4. Un dispositif selon l'une quelconque des revendications 1 à 3 caractérisé en ce que, pour augmenter la capacité de l'ensemble des moyens de stockage, les tensions de polarisation ($V_{GST}$, $V_{GST1}$, $V_{GST2}$) des moyens de stockage supplémentaires sont portées successivement, en fonction de la quantité de charge intégrée à un niveau haut identique au niveau haut ou supérieur au niveau de précharge du premier moyen de stockage (D' et $G_1$, $G_{ST1}$).

5. Un dispositif selon l'une quelconque des revendications 1 à 3 caractérisé en ce que, pour augmenter la capacité de l'ensemble des moyens de stockage, les tensions de polarisation ($V_{GST}$, $V_{GST1}$, $V_{GST2}$) des moyens de stockage supplémentaires sont portées successivement en fonction de la quantité de charge intégrée à un niveau haut inférieur au niveau haut ou au niveau de précharge du premier moyen de stockage (D' et $G_1$, $G_{ST1}$), les différentes tensions de polarisation s'accroîssant ou étant identique du dernier moyen de stockage supplémentaire au premier moyen de stockage supplémentaire.

6. Un dispositif selon l'une quelconque des revendications 1 à 5 caractérisé en ce que la diode (D') de l'étage de conversion charge-tension ($M_{I2}$) et la grille ($G_4$) du moyen de remise à niveau ($M_{I3}$) sont adjacentes au premier moyen de stockage utilisé (D', $G_{ST1}$).

7. Un dispositif selon l'une quelconque des revendications 1 à 6, caractérisé en ce que le multiplexeur est constitué par un registre à décalage logique (R) à entrée série et sorties parallèles dont chaque sortie est reliée par l'intermédiaire d'un interrupteur ($M_{I2}$) à un des étages de conversion charge-tension.

8. Un dispositif selon l'une quelconque des revendications 1 à 6 caractérisé en ce que le multiplexeur est constitué par un registre (R') à décalage à transfert de charge à entrées parallèles et à sortie série dont chaque entrée est connectée à une cellule d'intégration et de stockage et dont la sortie est connectée à l'étage de conversion charge-tension par l'intermédiaire des moyens de stockage supplémentaires ($G'_{ST2}$) et du premier moyen de stockage ($G'_{ST1}$).

**Patentansprüche**

1. Photoempfindliche Festkörpervorrichtung vom Typ mit wenigstens einem photoempfindlichen Detektor (3), wobei jeder Detektor mit einer Ladungsintegrationszelle (1) verbunden ist, die ihrerseits durch einen Multiplexer (R, $M_{I2}$, R') mit einer Ladungs/Spannungs-Umsetzstufe ($M_{I1}$, $D_1$) verbunden ist, der ein erstes Speichermittel (D' und $G_1$, $G_{ST1}$, $G'_{ST1}$) vorausgeht, das mit einem Pegelrücksetzmittel ($M_{I3}$) verbunden ist, dadurch gekennzeichnet, dass sie ferner wenigstens ein zusätzliches Ladungsspeichermittel ($G_{ST}$, $G_{ST2}$, $G'_{ST2}$) aufweist, das dem ersten Speichermittel (D' und $G_1$, $G_{ST1}$, $G'_{ST1}$) benachbart ist, wobei das oder die zusätzlichen Speichermittel durch veränderliche Polarisationsspannungen ($V_{GST}$, $V_{GST1}$, $V_{GST2}$, $V'_{GST2}$) gesteuert sind, die eine Veränderung der Kapazität der Gesamtheit der Speichermittel in Abhängigkeit von der integrierten Ladungsmenge ermöglichen.

2. Vorrichtung nach Anspruch 1, dadurch gekennzeichnet, dass das erste Ladungsspeichermittel aus der Lesediode (D') der Ladungs/Spannungs-Umsetzstufe besteht und dass das oder die zusätzlichen Speichermittel ($G_{ST}$, $G_{ST1}$, oder $G_{ST2}$) aus MOS-Kapazitäten bestehen.

3. Vorrichtung nach Anspruch 1, dadurch gekennzeichnet, dass das erste Speichermittel ($G_{ST1}$, $G'_{ST1}$) und das oder die zusätzlichen Speichermittel ($G_{ST2}$, $G'_{ST2}$) aus MOS-Kapazitäten bestehen.

4. Vorrichtung nach einem der Ansprüche 1 bis 3, dadurch gekennzeichnet, dass, um die Kapazität der Gesamtheit der Speichermittel zu erhöhen, die Polarisationsspannungen ($V_{GST}$, $V_{GST1}$, $V_{GST2}$) der zusätzlichen Speichermittel, nacheinander und in Abhängigkeit von der integrierten Ladungsmenge auf einen hohen Pegel gelegt werden, der gleich dem hohen Pegel bzw. grösser als der Vorladepegel des ersten Speichermittels (D' und $G_1$, $G_{ST1}$) ist.

5. Vorrichtung nach einem der Ansprüche 1 bis 3, dadurch gekennzeichnet, dass, um die Kapazität der Gesamtheit der Speichermittel zu erhöhen, die Polarisationsspannungen ($V_{GST}$, $V_{GST1}$, $V_{GST2}$) der zusätzlichen Speichermittel nacheinander, in Abhängigkeit von der integrierten Ladungsmenge, auf einen hohen Pegel, der kleiner als der hohe Pegel oder der Vorladepegel des ersten Speichermittels (D' und $G_1$, $G_{ST1}$) ist, gelegt werden, wobei die verschiedenen Polarisationsspannungen vom letzten zusätzlichen Speichermittel zum ersten zusätzlichen Speichermittel grösser werden oder gleich bleiben.

6. Vorrichtung nach einem der Ansprüche 1 bis 5, dadurch gekennzeichnet, dass die Diode (D') der Ladungs/Spannungs-Umsetzstufe ($M_{I2}$) und die Elektrode ($G_4$) des Pegelrücksetzmittels ($M_{I3}$) dem ersten benutzten Speichermittel (D', $G_{ST1}$) benachbart sind.

7. Vorrichtung nach einem der Ansprüche 1 bis 6, dadurch gekennzeichnet, dass der Multiplexer aus einem logischen Schieberegister (R) besteht, mit seriellem Eingang und parallelen Ausgängen, wovon jeder Ausgang über einen Unterbrecher

($M_{I2}$) mit einer der Ladungs/Spannungs-Umsetzstufe verbunden ist.

8. Vorrichtung nach einem der Ansprüche 1 bis 6, dadurch gekennzeichnet, dass der Multiplexer aus einem Ladungsüberführung-Schieberegister (R') mit parallelen Eingängen und mit seriellem Ausgang gebildet ist, wovon jeder Eingang mit einer Integrations- und Speicherzelle verbunden ist, und dessen Ausgang mit der Ladungs/Spannungs-Umsetzstufe über zusätzliche Speichermittel ($G'_{ST2}$) und über das erste Speichermittel ($G'_{ST1}$) verbunden ist.

## Claims

1. A solid state photosensitive device of the type comprising at least one photosensitive detector (3), each detector being connected with a charge integrating cell (1) which itself is connected by the intermediary of a multiplexer (R, $M_{I2}$, and R') with a charge voltage conversion stage ($M_{I1}$, $D_1$) preceded by a first hold means (D' and $G_1$, $G_{ST1}$ and $G'_{ST1}$) connected with a level resetting means ($M_{I3}$) characterized in that it furthermore comprises at least one supplementary charge hold means ($G_{ST}$, $G_{ST2}$, $G'_{ST2}$) adjacent to the first supplementary charge hold means (D' and $G_1$, $G_{ST1}$, and $G'_{ST1}$), the one or more supplementary hold means being controlled by adjustable polarizing voltages ($V_{GST}$, $V_{GST1}$, $V_{GST2}$ and $V'_{GST2}$) making it possible to modify the capacity of the overall holding means as a function of the quantity of integrated charge.

2. The device as claimed in claim 1 characterized in that the first charge hold means is constituted by the read diode (D') of the charge-voltage conversion means and the one or more supplementary hold means are contituted by the MOS capacitors ($G_{ST}$, $G_{ST1}$ or $G_{ST2}$).

3. The device as claimed in claim 1 characterized in that the first hold means ($G_{ST1}$ and $G'_{ST1}$) and the one or more supplementary hold means ($G_{ST2}$ and $G'_{ST2}$) are in the form of MOS capacitors.

4. The device as claimed in any one of the claims 1 to 3 characterized in that, in order to increase the capacity of the overall hold means, the polarization voltages ($V_{GST}$, $V_{GST1}$, and $V_{GST2}$) of the supplementary hold means are placed successively, as a function of the charge integrated at an identical high level, at the high level or at the level higher than the precharge of the first hold means (D' and $G_1$ and $G_{ST1}$).

5. The device as claimed in any one of the claims 1 to 3 characterized in that, in order to augment the capacity of the overall hold means, the polarization voltages ($V_{GST}$, $V_{GST1}$ and $V_{GST2}$) of the supplementary hold means are placed successively and according to a function of the quantity of integrated charge at a high level less than the high level or at the level of precharge of the first hold means (D' and $G_1$ and $G_{ST1}$), the different polarization voltages, increasing or being identical, from the last supplementary hold means to the first supplementary hold means.

6. The device as claimed in any one of the claims 1 to 5 characterized in that the diode (D') of the charge voltage conversion stage ($M_{I2}$) and the grid ($G_4$) of the level resetting means ($M_{I3}$) are adjacent to the first hold means (D' and $G_{ST1}$) utilized.

7. The device as claimed in any one of the claims 1 to 6 characterized in that the multiplexer is constituted by a logical shift register (R) with a serial output and with parallel outputs, of which each is connected by the intermediary of an interrupter ($M_{I2}$) with one of the charge-voltage conversion means.

8. The device as claimed in any one of the claims 1 to 6 charcterized in that the multiplexer is constituted by a charge transfer shift register (R') with parallel inputs and a serial output, of which each input is connected with an integration and hold cell and of which the output is connected with the charge-voltage conversion stage by the intermediary of the supplementary hold means ($G'_{ST2}$) and of the first hold means ($G'_{ST1}$).

FIG_1

0 149 948

# FIG_2

FIG_3-a

$V_{GC}$  $V_{GST}$

$V_{RAZ}$

$3$  $7$

$V_{SD}$

$G_C$  $G_{ST}$  $G_4$

$P$  $N^+_1$  $D$  $N^+_2$

FIG_3-b

$e^-$

$Q$

$V_{RAZ}$

Potentiels

FIG_3-c

$e^-$

$Q$

$V_{RAZ}$

FIG_3-d

$Q$

$V_{RAZ}$

0 149 948

4/6

FIG_5-a

FIG_5-b

FIG_5-c

FIG_5-d

FIG_5-e

FIG_4

FIG_6

FIG_7-a   FIG_7-b   FIG_7-c

# FIG_8-a

# FIG_8-b

0 149 948

6/6

19